# FASCICULE DE BREVET EUROPEEN

(11) **EP 0 709 804 B1**
(45) Date de publication et mention de la délivrance du brevet: **21.10.1998**
(21) Numéro de dépôt: 95401885.9
(22) Date de dépôt: 11.08.1995
(51) Int. Cl.: G06K 19/077

(54) **Procédé de fabrication de cartes sans contact**
Verfahren zum Herstellen von kontaktlosen Karten
Process of fabricating contactless cards

(30) Priorité: 13.09.1994 FR 9410920
(43) Date de publication de la demande: 01.05.1996
(73) Titulaire: GEMPLUS S.C.A., F-13420 Gemenos (FR)
(72) Inventeur: Gloton, Jean-Piere, F-75116 Paris (FR)
(74) Mandataire: Ballot, Paul Denis Jacques

(56) Documents cités:
- EP-A- 0 481 776
- EP-A- 0 671 705
- DE-U- 8 909 783

## Description

L'invention concerne un procédé de fabrication de cartes ou objets portables sans contact comportant une antenne noyée dans un corps de carte et connectée, par ses bornes de connexion, aux plages de contact d'un module électronique ou électrique.

L'invention ne concerne pas uniquement des cartes ayant exclusivement un fonctionnement sans contact. Elle concerne en outre des cartes dites mixtes, qui possèdent à la fois un fonctionnement sans contact et un fonctionnement par contacts. Aussi, dans la présente description, on appellera carte sans contact, une carte ou un objet portable dont le fonctionnement est, indifféremment, exclusivement sans contact ou alors mixte.

Les cartes sans contact sont destinées à la réalisation de diverses opérations, telles que, par exemple, des opérations de débit, des opérations bancaires, des communications téléphoniques, ou diverses opérations d'identification. Elles sont destinées, en particulier, à des opérations du type télébillétique dans lesquelles elles sont débitées à distance d'un certain nombre d'unités lors d'un passage à proximité d'une borne et où elles peuvent être rechargées à distance également. Dans le cas d'une carte mixte, le rechargement s'effectue dans un distributeur classique de carte à contacts.

Les opérations à distance précitées s'effectuent grâce à un couplage électromagnétique entre l'électronique de la carte et un appareil récepteur ou lecteur. Ce couplage s'effectue en mode lecture ou en mode lecture/écriture et la transmission des données s'effectue par radiofréquences ou hyperfréquences.

Telles qu'elles sont réalisées actuellement, les cartes sans contact sont des objets portables aux dimensions normalisées. La norme usuelle, ISO 7810 correspond à une carte de format standard de 85 mm de longueur, de 54 mm de largeur, et de 0,76 mm d'épaisseur.

On connaît des procédés de fabrication de cartes sans contact par colamination. Dans de tels procédés, on dispose, entre deux plateaux d'une presse, un empilement de feuilles thermoplastiques au milieu duquel on place un module électronique sans contact déjà connecté à une antenne. On effectue ensuite le soudage de ces différentes feuilles en appliquant pression et température.

Toutefois, du fait des différences de coefficient de dilatation entre les matériaux utilisés, l'action combinée de la pression et de la température engendre une déformation résiduelle inesthétique à la surface de la carte et en regard du module électronique.

On connaît d'autres procédés de fabrication de cartes sans contact qui mettent en oeuvre une simple dispense de matière plastique fluide dans une cavité ouverte d'un moule où l'on a placé une feuille thermoplastique sur laquelle repose une antenne déjà connectée à un module électronique. La matière forme alors une couche uniforme qui recouvre entièrement l'antenne et le module.

De tels procédés ne sont pas adaptés à une fabrication à forte rentabilité de cartes en série. En effet, ils ne permettent pas un report différé du module électronique dans une étape ultérieure à la dispense de matière et les rebuts, qui contiennent le module électronique, augmentent considérablement le prix de revient moyen d'un carte. En outre, ces procédés ne permettent pas l'obtention immédiate de cartes mixtes.

La demande de brevet EP-A-0 671 705 - faisant partie de l'état antérieur de la technique au titre de l'article 54(3) de la CBE - décrit un procédé de fabrication de cartes sans contact dans lequel l'antenne et le module électronique sont insérés dans une seule et même couche formant le corps de carte. Le procédé consiste à placer l'antenne sur une feuille thermoplastique, puis à la recouvrir par une couche thermoplastique à l'exception de ses bornes de contact. Pour cela, le moule permettant de réaliser la couche thermoplastique comporte un noyau destiné à exercer une pression suffisamment forte sur les bornes de connexion de l'antenne afin d'éviter qu'elles soient recouvertes de matière plastique. Ce procédé permet le report différé du module électronique dans la cavité formée dans la couche au-dessus des bornes de contact de l'antenne. Cependant, la pression exercée sur les bornes de connexion de l'antenne entraîne souvent une dégradation de leur qualité si bien qu'un nombre important de cartes est destiné au rebut. Par conséquent, ce procédé n'est pas non plus adapté à une fabrication à forte rentabilité de cartes en série.

D'autres procédés encore visent la fabrication de cartes à contact par injection de matière plastique liquide sous forte pression dans une cavité fermée d'un moule. Ces procédés pourraient être transposables à la réalisation des cartes sans contact.

Mais l'antenne, qui est particulièrement fragile, peut alors être soumise aux contraintes de la pression d'injection, ce qui rend le procédé critique et accroît la quantité de cartes rebuts. En outre, lors de l'injection, le module électronique est déjà connecté à l'antenne, ce qui grève le prix de revient des cartes obtenues.

Le document DE-U-89 09 783 décrit un procédé de fabrication d'un support de code permettant l'identification et/ou le marquage sans contact d'objets. Ce procédé consiste à noyer un noyau de ferrite, renfermant une bobine, et une puce connectée à la bobine, dans une enveloppe thermoplastique ou thermodurcissable. La matière plastique destinée à former l'enveloppe est injectée dans une cavité fermée d'un moule dans lequel est fixé le noyau en ferrite et la puce. Dans ce cas, la pression d'injection peut endommager la puce et ses connexions avec la bobine. Par conséquent, les supports rebuts renfermant déjà la puce, ce procédé est coûteux, peu rentable, et ne peut être adapté à une fabrication de cartes en grande masse.

La présente invention a pour but de proposer un procédé de fabrication de cartes sans contact à faible prix de revient, qui pallie les inconvénients précités des procédés de l'état de la technique, et qui permette notamment, la possibilité d'un report du module électronique dans une étape différée, en vue d'obtenir des cartes sans contact ne présentant pas de déformation au regard du module électronique.

Ce but, ainsi que d'autres qui apparaîtront par la suite, sont atteints grâce à un procédé de fabrication de carte sans contact, dans lequel on dispense une matière liquide sur une antenne, puis on répartit ladite matière, de manière à ce qu'elle soit guidée, dans son parcours, par l'antenne elle-même.

Ainsi, l'invention a pour objet un procédé de fabrication de cartes sans contact comportant une antenne noyée dans un corps de carte et connectée, par ses bornes de connexion, aux plages de contact d'un module électronique du corps de carte, caractérisé en ce qu'il comprend les étapes suivantes, selon lesquelles :
- on place l'antenne dans une cavité d'un moule;
- on dispense et on répartit une matière plastique liquide dans la cavité du moule de manière à ce que ladite matière soit guidée par l'antenne, en vue de former une première couche du corps de carte ne recouvrant pas l'antenne et en particulier ses bornes de connexion.

La description qui va suivre, et qui ne présente aucun caractère limitatif, permettra de mieux comprendre la manière dont l'invention peut être mise en pratique.

Elle doit être lue au regard des dessins annexés, dans lesquels :
- la figure 1 illustre, en perspective, la dispense et la répartition guidée de la matière plastique liquide selon le procédé de l'invention ;
- la figure 2 illustre, en coupe transversale, des moyens de pression mis en oeuvre pour la répartition de la matière plastique liquide selon le procédé de l'invention ;
- la figure 3 montre, en coupe transversale, une étape de report du module électronique selon un mode de mise en oeuvre du procédé de l'invention. Ce report peut être effectué avant ou après l'étape de la figure 1;
- les figures 4 et 5 montrent, en coupe transversale, l'étape de report du module électronique selon un autre mode de mise en oeuvre du procédé de l'invention ; et
- la figure 6 représente, en coupe transversale, une carte sans contact, obtenue selon un des modes de mise en oeuvre du procédé de l'invention.

L'invention concerne un procédé de fabrication de cartes sans contact. De telles cartes comportent une antenne 1 noyée dans un corps de carte 2 et connectée, par ses bornes de connexion 3, aux plages de contact 4 d'un module électronique 5.

Le corps de carte 2 forme un parallélépipède rectangle de faible épaisseur composé de différentes couches de matière plastique 6, 7, 8.

L'antenne 1 est placée dans une couche 7 du corps de carte 2 comprise entre une feuille thermoplastique inférieure 6 et une couche supérieure 8. Elle est constituée, par exemple, d'un diélectrique métallisé ou contre-collé avec du métal formant une spirale de n spires. Le flux électromagnétique traversant l'antenne 1 est proportionnel au nombre n de spires qu'elle comporte et à la surface délimitée par lesdites spires. Aussi, n est avantageusement le plus grand possible et la conformation des spires suit sensiblement les bords du corps de carte 2. Cependant, les figures de la présente description montrent une antenne 1 en forme de spirale comportant, dans un souci de clarté, deux spires et laissant la partie centrale de la feuille 6 entièrement dégagée. Les extrémités de la spirale formant l'antenne 1 constituent les bornes de connexion 3 qui sont situées à proximité l'une de l'autre. Par ailleurs, l'antenne 1 peut être réalisée par différentes méthodes et notamment par estampage, par gravure chimique, ou par le dépôt d'un promoteur d'adhérence sur une feuille thermoplastique par sérigraphie puis métallisation par dépôt chimique.

Le module électronique 5 est placé dans la couche 8. Il comporte par exemple une puce à circuits intégrés 9 connectée par l'intermédiaire de fils conducteurs 10 à un ensemble de plots métalliques situés à sa périphérie. Deux de ces plots forment les plages de contact 4. Les autres plots forment des métallisations 11, destinées à un fonctionnement par contacts de la carte sans contact. Les métallisations 11 affleurent donc à la surface du corps de carte 2. La puce 9, les fils 10, et les plots 4, 11 sont figés dans une résine de protection 12.

Dans une première étape préférée du procédé de l'invention, on dépose la feuille plastique 6 au fond d'une cavité 13 d'un moule 14.

Cette cavité 13 est par exemple ouverte. Elle comporte un fond plan et des parois latérales verticales. Ses dimensions, longueur et largeur, sont sensiblement égales aux dimensions, longueur et largeur, de la carte que l'on veut obtenir. Toutefois, sa profondeur est supérieure ou égale à l'épaisseur de la carte que l'on veut obtenir.

La feuille 6 vient au contact des parois verticales de la cavité 13. L'épaisseur de cette feuille 6 est de l'ordre de 180 micromètres pour une carte standard correspondant à la norme ISO 7810. Elle est composée de PVC (chlorure de polyvinyle), d'un PC (polycarbonate), d'ABS (acrylonitrile butadiène styrène), de PET (polyéthylène), de PETG (polytéréphtalate d'éthylène glycol), de PVDF (polyfluorure de vinylidène) ou de tout autre film thermoplastique de propriétés équivalentes.

Dans une seconde étape du procédé, on place et, éventuellement, on colle l'antenne 1 sur la feuille 6.

Cette seconde étape peut être réalisée avant la première étape. Le terme "placer" doit se comprendre dans un sens large, incluant notamment la méthode de réalisation sérigraphique de l'antenne 1 mentionnée précédemment.

Par ailleurs, l'antenne peut aussi être surmoulée dans un moule qui la reçoit entièrement et être collée sur la feuille thermoplastique après le surmoulage. Le moule de surmoulage peut avoir une hauteur limitée exactement à l'épaisseur de l'antenne.

Dans une troisième étape, on dispense une matière plastique liquide 15 à la surface de la feuille 6 sur laquelle repose l'antenne 1.

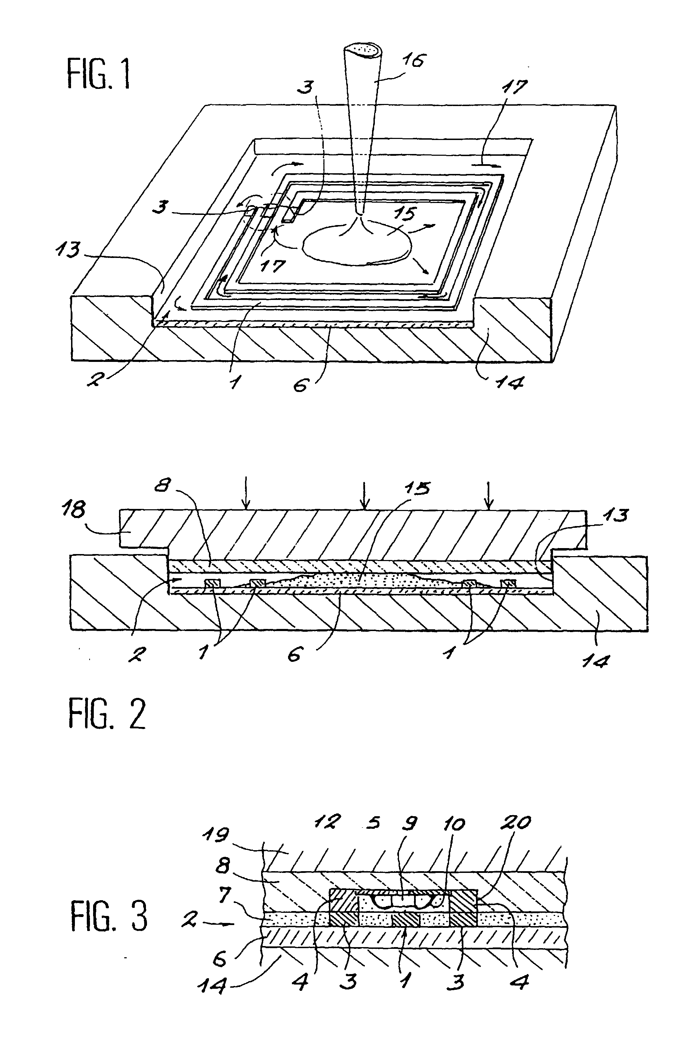

La matière 15 est dispensée par le dessus de la cavité 13, grâce aux procédés connus de l'art antérieur permettant de dispenser des liquides en quantités déterminées. Le terme liquide est ici utilisé à l'inverse du terme pateux. On a représenté cette dispense par une seringue ou une micropipette avec un embout 16 en figure 1. La dispense est effectuée sous une pression faible et très inférieure à la pression de 700 kg/cm² couramment mise en oeuvre dans les procédés de fabrication de carte avec injection de matière dans des cavités fermées de faible profondeur. Une telle pression est inférieure à 100 kg/cm².

Le micromodule peut être présent, connecté aux bornes de connexion de l'antenne 1, lors de la dispense ou injection de la matière 15.

La matière 15 est destinée à former la couche 7 du corps de carte 2. Elle est composée, par exemple, d'ABS, d'un PC, d'ABS/PC, de PET, d'un polyamide, ou de tout autre résine liquide à une certaine température ou dans certaines conditions de pression, préférentiellement d'indice de fluidité élevé afin de favoriser l'écoulement, et durcissable à une autre température, dans d'autres conditions, ou alors en présence d'un catalyseur en particulier polyuréthane, époxyphénolique modifiée ou non. La couche 7 a une épaisseur sensiblement égale à l'épaisseur de l'antenne 1, c'est-à-dire, dans l'exemple de la présente description, sensiblement égale à 80 micromètres. La matière 15 est ainsi dispensée directement sur la feuille 6 sans qu'elle recouvre l'antenne 1 et, en particulier, ses bornes de connexion. De plus, le volume de matière 15 dispensée est calculé avec justesse afin que la couche 7 montre, malgré la présence de l'antenne 1, une surface plane.

Dans un mode de réalisation avantageux de l'invention, la matière 15 est dispensée sensiblement au centre de la face supérieure de la feuille 6, c'est-à-dire à l'endroit le plus éloigné de l'antenne 1. Aussi, la possibilité pour que le dépôt de matière 15 dispensée recouvre l'antenne 1, même partiellement, sera minimale.

Dans une quatrième étape de l'invention, on répartit la matière plastique liquide 15 à la surface de la feuille 6, de manière à ce que ladite matière 15 soit guidée, dans son parcours, par l'antenne 1, en vue de former la couche 7 du corps de carte 2.

Dans le cas de l'exemple de la présente description, l'antenne 1 a une configuration en spirale. La répartition s'effectue donc en spirale, selon le parcours indiqué par les flèches 17.

Cette répartition s'effectue, par exemple, grâce à un pressage progressif de la matière 15 à l'aide d'un moyen de pressage, qui peut consister, comme le montre la figure 2, en une pièce 18 aux dimensions, longueur et largeur, sensiblement inférieures aux dimensions, longueur et largeur, de la cavité 13. La pièce 18 s'insère dans ladite cavité 13 et repousse alors le dépôt de matière liquide 15 selon le parcours de répartition précité 17. De préférence, on chauffe pour faire fondre la matière déposée et on presse progressivement.

La répartition de la matière 15 est réalisée de manière à ce que les bornes de connexion 3 de l'antenne 1 ne soient pas recouvertes par ladite matière 15.

Lorsque la matière 15 est solidifiée, après refroidissement (dans le cas d'un thermoplastique) ou polymérisation (dans le cas d'un thermodurcissable), on obtient une structure de carte intermédiaire formée de la feuille thermoplastique 6 (éventuellement) sur laquelle repose la couche 7 dont l'épaisseur est traversée par l'antenne 1.

Les étapes ultérieures visent, le report du module électronique 5 sur la structure précitée, la connexion de ce module 5 aux bornes 3 de l'antenne 1, et la formation de la couche 8 recouvrant la couche 7. Dans un exemple, l'épaisseur de la couche 8 est de 500 micromètres.

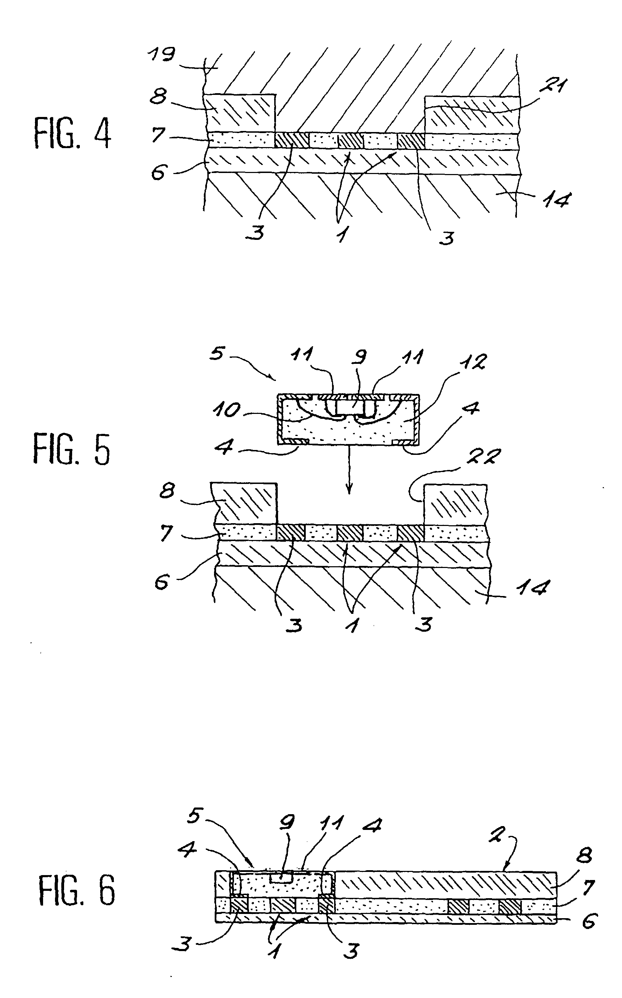

Selon un premier mode de réalisation montré en figure 3, on reporte le module 5 grâce à une pièce 19. Cette pièce 19 maintient la couche 8 destinée à venir s'appliquer à la surface de la couche 7.

La couche 8, obtenue de préférence par un moulage préalable, comporte un logement 20 dans lequel on a aussi préalablement inséré le module 5. Ce logement 20 est situé de manière à ce que les plages de connexion du module 5 affleurent à la surface inférieure de la couche 8 et viennent, lors de l'application de ladite couche 8 sur la couche 7, au contact des bornes de connexion 3 de l'antenne 1. En outre, la couche 8 comporte avantageusement, sur sa face inférieure, une colle qui améliore sa fixation à la couche 7.

Selon un second mode de réalisation montré aux figures 4 et 5, la pièce 19 comporte un noyau 21 destiné à former, après l'application de la couche 8 sur la couche 7, une cavité 22 de profondeur égale à l'épaisseur de la couche 8 pour le report du module 5.

Pour la mise en oeuvre de l'invention dans la fabrication de cartes en série, on pourra avantageusement utiliser des bandes perforées du type de celle qui sont décrites dans le brevet français déposé au nom de la demanderesse et publié sous le numéro 2 673 041.

Quelque soit le mode de réalisation employé, on obtient, après assemblage avec contre collage (thermoplastique ou adhésif) de la couche 8 sur la couche 7 ou démoulage des deux couches 7 et 8 fabriquées dans un même moule, une carte sans contact. Une telle carte, du type de celle représentée en figure 6, montre une feuille inférieure 6 sur laquelle repose une couche 7 dont l'épaisseur est égale à l'épaisseur de l'antenne 1, ladite couche 7 étant recouverte de la couche 8 comportant le module 5.

## Revendications

1. Procédé de fabrication de cartes sans contact comportant une antenne (1) noyée dans un corps de carte (2) et connectée, par ses bornes de connexion (3), aux plages de contact (4) d'un module électronique (5) du corps de carte (2), caractérisé en ce qu'il comprend les étapes suivantes, selon lesquelles :
- on place l'antenne (1) dans une cavité (13) d'un moule (14);
- on dispense et on répartit une matière plastique liquide (15) dans la cavité (13) du moule (14), de manière à ce que ladite matière soit guidée par l'antenne (1), en vue de former une première couche (7) du corps de carte (2) ne recouvrant pas l'antenne (1) et en particulier ses bornes de connexion.

2. Procédé selon la revendication 1, caractérisé en ce que l'on forme, au dessus de la première couche (7), une deuxième couche (8) destinée à recevoir le module électronique (5).

3. Procédé selon l'une des revendications précédentes, caractérisé en ce que la dispense de matière plastique liquide est réalisée sous une pression inférieure à 100 kg/cm².

4. Procédé selon l'une des revendications 2 à 3, caractérisé en ce que la première couche (7) et la deuxième couche (8) du corps de carte (2) sont réalisées sur des bandes perforées.

5. Procédé selon l'une des revendications précédentes, caractérisé en ce que , préalablement à la dispense, on dépose une feuille plastique (6) dans la cavité (13) du moule (14) et en ce que l'antenne (1) est alors placée sur ladite feuille (6).

6. Procédé selon l'une des revendications précédentes, caractérisé en ce que l'on dispense la matière plastique liquide (15) au centre de la face supérieure de la feuille plastique (6).

7. Procédé selon l'une des revendications précédentes, caractérisé en ce que la cavité (13) du moule (14) dans laquelle on dépose la feuille (6) a des dimensions, longueur et largeur, sensiblement égales aux dimensions, longueur et largeur, de la carte sans contact.

8. Procédé selon l'une des revendications précédentes, caractérisé en ce que la répartition s'effectue par pressage de la matière (15) à l'aide d'un moyen de pressage (18).

9. Procédé selon l'une des revendications précédentes, caractérisé en ce que la répartition s'effectue en spirale, l'antenne (1) ayant elle-même un conformation en spirale.

10. Procédé selon l'une des revendications 2 à 9, caractérisé en ce que la deuxième couche (8) comporte un logement (20) dans lequel on a préalablement inséré le module électronique (5).

11. Carte obtenable par le procédé selon l'une des revendications 1 à 10, comportant une antenne (1) noyée dans un corps de carte (2) et connectée, par ses bornes de connexion (3), aux plages de contact (4) d'un module électronique (5) du corps de carte (2), et comportant une première feuille thermoplastique (6) sur laquelle repose l'antenne (1), la carte étant caractérisée en ce qu'elle comporte une première couche (7) dont l'épaisseur est identique à celle de l'antenne (1), et une deuxième couche (8) appliquée sur la première couche (7) et comprenant le module électronique (5).

## Patentansprüche

1. Verfahren zum Herstellen von Karten ohne Kontakt mit einer Antenne (1), eingegossen in einem Kartenkörper (2) und verbunden über Verbindungsanschlüsse (3) mit Kontaktflächen (4) eines Elektronikmoduls (5) des Kartenkörpers (2),
dadurch **gekennzeichnet**, daß
es die folgenden Schritte aufweist, nach denen: man die Antenne (1) in einem Hohlraum (13) einer Gußform positioniert;
man ein flüssiges Plastikmaterial (15) in dem Hohlraum (13) der Gußform (14) ausbreitet und verteilt, derart, daß das Material durch die Antenne (1) geführt wird, um eine erste Schicht (7) des Kartenkörpers (2) zu bilden, ohne die Antenne (1) und insbesondere ihre Verbindungsanschlüsse zu bedecken.

2. Verfahren nach Anspruch 1, dadurch gekennzeichnet, daß man oberhalb der ersten Schicht (7) eine zweite Schicht (8) bildet, die dazu dient, das Elektronikmodul (5) aufzunehmen.

3. Verfahren nach einem der vorangehenden Ansprüche,
dadurch gekennzeichnet, daß
die Verteilung des flüssigen Plastikmaterials unter einem Druck von weniger als 100 kg/cm² erfolgt.

4. Verfahren nach einem der Ansprüche 2 bis 3,
dadurch gekennzeichnet, daß
die erste Schicht (7) und die zweite Schicht (8) des Kartenkörpers (2) auf perforierten Banden erzeugt werden.

5. Verfahren nach einem der vorangehenden Ansprüche,
dadurch gekennzeichnet, daß
vor dem Verteilen eine Plastikfolie (6) in dem Hohlraum (13) der Gußform (14) angeordnet wird, und daß die Antenne (1) danach auf der Folie (6) angeordnet wird.

6. Verfahren nach einem der vorangehenden Ansprüche,
dadurch gekennzeichnet, daß
das flüssige Plastikmaterial (15) in der Mitte der oberen Fläche der Plastikfolie (6) verteilt wird.

7. Verfahren nach einem der vorangehenden Ansprüche,
dadurch gekennzeichnet, daß
der Hohlraum (13) der Gußform (14), in welcher man die Folie (6) angeordnet hat, Dimensionen in Länge und Breite hat, die im wesentlichen gleich den Dimensionen in Länge und Breite der Karte ohne Kontakt sind.

8. Verfahren nach einem der vorangehenden Ansprüche,
dadurch gekennzeichnet, daß
die Verteilung durch Druckausübung auf das Material (15) mit Hilfe einer Druckvorrichtung (18) erfolgt.

9. Verfahren nach einem der vorangehenden Ansprüche,
dadurch gekennzeichnet, daß
die Verteilung spiralförmig erfolgt, wobei die Antenne (1) selbst die Form einer Spirale hat.

10. Verfahren nach einem der Ansprüche 2 bis 9,
dadurch gekennzeichnet, daß
die zweite Schicht (8) eine Aufnahme (20) aufweist, in welcher man vorher das Elektronikmodul (5) angeordnet hat.

11. Karte, die mit dem Verfahren nach einem der Ansprüche 1 bis 10 hergestellt werden kann, welche eine Antenne (1) umfaßt, die in einem Kartenkörper (2) eingegossen ist und verbunden ist über ihre Verbindungsanschlüsse (3) mit Kontaktflächen (4) eines Elektronikmoduls (5) des Kartenkörpers (2), und die eine erste thermoplastische Folie (6) aufweist, auf welcher die Antenne (1) liegt, wobei die Karte dadurch gekennzeichnet ist, daß sie umfaßt:
eine erste Schicht (7), deren Dicke identisch mit der der Antenne (1) ist, und eine zweite Schicht (8), die auf der ersten Schicht (7) liegt und das Elektronikmodul (5) umfaßt.

## Claims

1. A method of manufacturing cards without contacts, having an antenna (1) embedded in a card base (2) and connected by means of its connection terminals (3) to the contact terminals (4) of an electronic module (5) of the card base (2), characterised in that it comprises the following steps, in which:
- the antenna (1) is placed in cavity (13) of a mould (14) ;
- a liquid plastics substance (15) is poured into and distributed in the cavity (13) of the mould (14) so that said substance is guided by the antenna (1) with a view to forming a first layer (7) of the card body (2) such that the antenna (1) and in particular the connection terminals thereof are not covered.

2. A method as claimed in claim 1, characterised in that a second layer (8) is formed on top of the first layer (7) for the purpose of receiving the electronic module (5).

3. A method as claimed in one of the preceding claims, characterised in that the liquid plastics substance is applied at a pressure below 10 kg/cm².

4. A method as claimed in one of claims 2 to 3, characterised in that the first layer (7) and the second layer (8) of the card body (2) are formed on perforated strips.

5. A method as claimed in one of the preceding claims, characterised in that before the application step, a plastic sheet (6) is laid in the cavity (13) of the mould (14) and the antenna (1) is placed on said sheet (6).

6. A method as claimed in one of the preceding claims, characterised in that the liquid plastics substance (15) is applied at the centre of the upper face of the plastic sheet (6).

7. A method as claimed in one of the preceding claims, characterised in that the cavity (13) of the mould (14) in which the sheet (6) is placed is of dimensions, length and width, substantially the same as the dimensions, length and width, of the card without contacts.

8. A method as claimed in one of the preceding claims, characterised in that the substance (15) is distributed by pressing using a press means (18).

9. A method as claimed in one of the preceding claims, characterised in that the distribution process is effected in a spiral, the antenna (1) itself being in a spiral.

10. A method as claimed in one of claims 2 to 9, characterised in that the second layer (8) has a recess (20) in which the electronic module (5) is inserted beforehand.

11. A card obtainable by the method as claimed in one of claims 1 to 10, having an antenna (1) embedded in a card body (2) and connected by means of its connecting terminals (3) to the contact terminals (4) of an electronic module (5) of the card body (2), and having a first thermoplastic sheet (6) on which the antenna (1) is laid, the card being characterised in that it has a first layer (7) of the same thickness as that of the antenna (1) and a second layer (8) applied onto the first layer (7) and containing the electronic module (5).
